(19) Europäisches Patentamt
European Patent Office
Office européen des brevets

(11) **EP 2 538 261 A1**

(12) **EUROPEAN PATENT APPLICATION**
published in accordance with Art. 153(4) EPC

(43) Date of publication:
**26.12.2012 Bulletin 2012/52**

(21) Application number: **11744305.1**

(22) Date of filing: **02.02.2011**

(51) Int Cl.:
*G02B 19/00* (2006.01)   *H01L 31/052* (2006.01)

(86) International application number:
**PCT/ES2011/070065**

(87) International publication number:
**WO 2011/101516 (25.08.2011 Gazette 2011/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.02.2010 ES 201030241**

(71) Applicant: **Abengoa Solar New Technologies, S.A. 41018 Sevilla (ES)**

(72) Inventors:
• **CAPARROS JIMENEZ, Sebastian** E-41018 Sevilla (ES)
• **ROWLEY DAVENPORT, Thomas Lewis** Tucson, Arizona 85711 (US)

(74) Representative: **Carvajal y Urquijo, Isabel Clarke, Modet & Co. c/ Goya, 11 28001 Madrid (ES)**

(54) **PHOTOVOLTAIC SOLAR CONCENTRATION SYSTEM**

(57)    Concentrated photovoltaic solar system with a Fresnel lens concentrator (1) with a constant facet thickness in a first area, particularly the central area of the lens (1), then having a constant facet height in a second area, particularly the peripheral area of the lens (1), in order to maximize the optical efficiency of the lens (1), maintaining the typical system aberrations under control. The concentrated photovoltaic solar system also comprises a secondary optical element 2 with a circular intake face (3) and convex curvature, a section to accommodate a rim (4), and a pyramidal section (6), the transverse section changing from a circle into a square in the lower end (7) where the photovoltaic receiver is housed. This system improves the optical and thermodynamic efficiency of the existing systems, facilitates the production and installation in the photovoltaic module, and reduces manufacturing-related costs.

FIG. 8

EP 2 538 261 A1

**Description**

## FIELD OF THE INVENTION

The present invention refers to the technical field of concentrated photovoltaic solar systems for the harnessing of solar energy for the production of electric energy, particularly to high-concentration photovoltaic solar systems, and more particularly to systems formed mainly by a Fresnel lens concentrator, a secondary optical element and a photovoltaic receiver.

## BACKGROUND OF THE INVENTION

Numerous concentrated photovoltaic (CPV) solar systems have been proposed and developed along the 20th century until our days. In spite of this long history, these systems are not competitive nowadays in terms of cost and efficiency with respect to traditional forms of energy production.

Documents WO2006114457, US2009106648 and WO 2009058603 show the typical working scheme of a concentrated photovoltaic solar system. Said system consists of a Fresnel lens light concentrator and a secondary optical element which provides the system with greater concentration. Several systems using Fresnel lenses have been proposed with and without secondary optical elements.

There exist other concentrated photovoltaic solar systems based on the Cassegrain technology. Said systems consist of a pair of mirrors and a tertiary homogenizing optical element. Also, there are other concentrated optical elements based on parabolic mirrors. Said systems can be formed by mirrors or they can be a completely solid system based on Total Internal Reflection (TIR), as shown in documents WO2009058603 and WO2009086293.

Recently, there have been reported light-guiding concentrated systems , as shown in document WO2008131566. Said systems are characterized by their greater compactness vis-à-vis traditional systems.

An ideal concentrated photovoltaic solar system should include the following characteristics to be competitive: minimizing losses in optical concentrated systems, that is, attaining greater optical efficiency; being an effective solution in cost and reliable in the long term; being compact and attaining maximum thermodynamic efficiency, that is, attaining the maximum degree of concentration possible, maintaining minimum manufacturing clearances.

Also, an ideal concentrated photovoltaic solar system should maximize the use of the etendue. The concept of etendue was described by Dr. Winston and Co. in Non Imaging Optics and is of great importance in a concentrated photovoltaic solar system. Maximizing the etendue means maximizing the acceptance angle of a system for a particular concentration degree, or maximizing the concentration for a - particular acceptance angle. A module of maximum use of etendue has potential to effectively concentrate solar radiation, minimizing the cost of the semiconductor element and consequently the module, and provide the system with the necessary tolerance to be mounted in real solar tracking systems, and allow manufacturing clearance of the module without that affecting the performance thereof.

The maximum degree of concentration that can be reached for an acceptance angle is defined by the following equation:

$$Cmax = \frac{(n^2 \cdot sin\,(\theta_1)^2)}{(sin\,(\theta_2))^2}$$

Where n is the refractive index of the medium in which the photovoltaic receiver is submerged, $\theta_1$ the intake angle in the photovoltaic cell and $\theta_2$ the acceptance angle in the system.

The concentrated photovoltaic solar systems through Fresnel lenses are the most widely used, since it is a known, standard and cost-effective technology. However, they are not excessively compact systems and they do not maximize the use of the etendue. Yet there have been published certain documents with the object of maximizing the use of the etendue using lens systems with very high focal lengths and secondary elements with certain curvature at the intake.

The reflexive systems are being progressively introduced, in general they are more compact than refractive systems, and with the appropriate design they maximize the use of etendue in comparison with lenses. However, they have smaller optical efficiencies and a greater number of elements.

The light-guiding systems are, by far, the most compact ones. However, they still have to show their optical efficiency, cost and reliability in the long term.

It was therefore desirable a system which attained a high photovoltaic solar concentration avoiding the existing inconveniencies in the previous systems of the state of the art..

## DESCRIPTION OF THE INVENTION

The present invention solves the existing problems in the state of the art by means of a concentrated photovoltaic solar system formed by a Fresnel lens concentrator, a secondary optical element and a photovoltaic receiver.

Fresnel lenses can usually be defined with two forms: with a constant facet thickness (equi-pitch), or with a constant facet height (equi-depth). Each one has its advantages and disadvantages.

Every design of a Fresnel lens tends to compensate two factors, one with the other: First, making the lens as efficient as possible, which is attained by maximizing the ratio between the facet thickness and its rounding in the peak, due to the film or mould production process.

Second, controlling the lens aberrations, which is attained basically by controlling the focal length into appropriate values and making the facet ,thickness as small as possible.

Compensating both effects is antagonistic. If it is intended to maximize the thickness with respect to the peak we have to use a constant height design. A constant height design has the central facets of the lens with a thickness that is too high, causing the off-axis behaviour of the lens due to aberrations not to be the desired one. This would reduce the acceptance angle of the system.

By contrast, a constant thickness design is usually made with a constant thickness in all facets which is less than 1mm, which causes the off-axis behaviour to be relatively better than in the previous case; however, the rounded peak occupies greater relative space in the total lens, making it less efficient.

The solution proposed in the present invention is a hybrid lens which has the advantages of both types of design. The central part of the lens will have a constant thickness of 1mm or less. As more facets are introduced, a maximum height point of said facet will be achieved (which depends on what each provider specifies according to their process). Once we arrive at this point, the design becomes a constant height design. Therefore, they are hybrid with constant thickness in the middle and constant height in the peripheral area.

This type of designs have the advantage of improving a couple of points the efficiency of the lens, presenting an acceptable behaviour with respect to off-axis aberrations, thus increasing the acceptance angle of the system.

The secondary optical elements have to be placed in the appropriate position in order to maximize the use of etendue. Dr. Winston described designs which enabled to attain reaching optical limits. Said limits were reached with F#=3, F# being =f/D, being:

f = focal length of the lens,
D = diagonal of the light intake face of the lens.

The optical elements of the lenses of the concentrated systems object of the present invention reach the limits in a quite lower F# range. A low F# implies more compact systems and reduced sized pieces, which leads to more cost-effective solutions.

The following table shows an increase in the system use of etendue as the F# increases.

| Case | F# | Real Cx | Acceptance angle (°) | Cmax | Square Cmax | Etendue % |
|---|---|---|---|---|---|---|
| 1 | 0.9 | 700 | 1.45 | 2882.5 | 1441.3 | 48.6% |
| 2 | 1.1 | 700 | 1.85 | 1771.0 | 885.5 | 79.1% |
| 3 | 1.2 | 700 | 1.91 | 1661.5 | 830.8 | 84.3% |
| 4 | 1.3 | 700 | 1.93 | 1627.3 | 813.7 | 86.0% |
| 5 | 1.4 | 700 | 1.94 | 1610.6 | 805.3 | 86.9% |
| 6 | 1.5 | 700 | 1.98 | 1546.2 | 773.1 | 90.5% |

An important increase in the system efficiency is observed when F# is changed from 0.9 (practical minimum in real systems) to 1.2. From this point of view the improvement is greatly relativized, the curve presenting asymptotic behaviour. Therefore, it is not convenient to use lenses with F# greater than 1.5 in these systems, since it would increase the cost of the system without providing any significant improvement. A compromise situation where F# = 1.2 has been estimated.

The secondary optical elements to be coupled with lenses comprised between the specified F# are characterized by a convex curve intake, a section to accommodate the rim and a truncated pyramid, the transverse section changing from circular into square, where the photovoltaic receiver will be housed.

The intake face has a circular intake section and is convex so that it adds optical capacity to the secondary optical element, allowing more compact structures and improving the efficiency. Said face is circular, due to the fact that said configuration enables a better capture of rays than the equivalent square surface, thus increasing the angular tolerance of the complete lens-secondary system.

Next, there is an inactive or active area where the rim is housed. Said rim entails an advantage in moulding manufacturing processes and allows the mechanic coupling of the secondary element inside the module. Likewise, it facilitates the post-processing of the pieces once they have been moulded. The rim can be integrated or not in the mould.

Finally, there is a truncated pyramid-shaped section which has an initial circular section coupled'to the rim, and an output square section, necessary to couple the chip. This type of secondary elements enable moulding processes with a minimum requirement for polish, minimizing operation times and piece costs. Also, the very high thermodynamic efficiency which can be reached with these designs is verified.

These secondary elements have the great advantage with respect to more conventional designs that they reach equal or higher degrees of concentration while providing a good acceptance angle which does not compromise the design of the tracker and the mounting process of the module itself, making this technology a very ati:ractive one.

## DESCRIPTION OF THE DRAWINGS

The following is a description of an embodiment of the invention presented as a nonlimiting example thereof which will facilitate the understanding of the invention referring to a series of drawings.

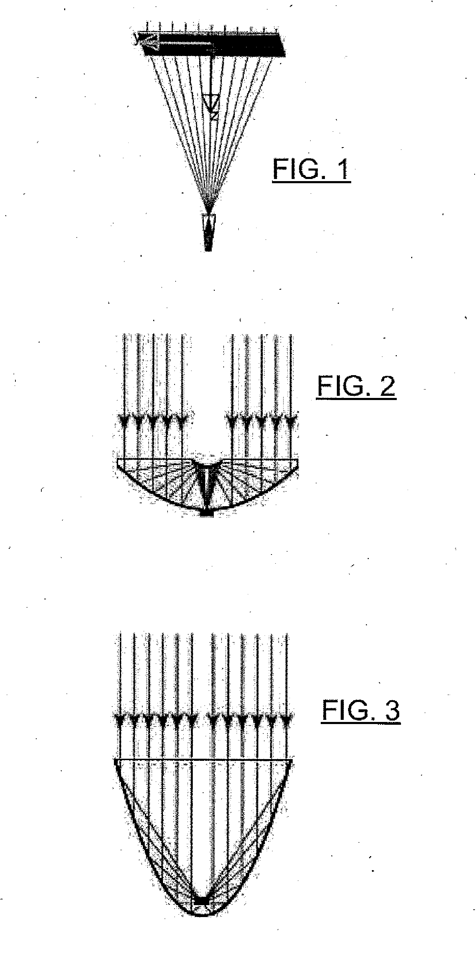

Figure 1 shows a typical operation scheme of a concentrated photovoltaic solar system known in the state of the art.

Figure 2 shows the operation of another concentrated photovoltaic solar system based on the Cassegrain technology, also known in the state of the art.

Figure 3 shows concentration optical elements based on parabolic mirrors, existing in the state of the art.

Figure 4 shows a light-guiding concentrated system, already existing in the state of the art.

Figure 5 shows the relation existing between thickness and roundness of a Fresnel lens concentrator.

Figure 6 shows the relation between F# and etendue of the system object of the present invention.

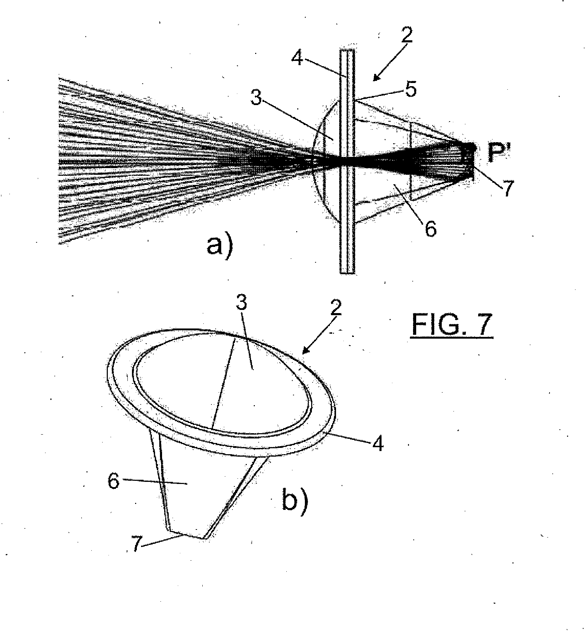

Figure 7 shows several views of the secondary optical element object of the present invention.

Figure 8 shows the parameters of a preferred embodiment of the lens of the system object of the present invention.

Figure 9 shows a preferred embodiment of the secondary optical element of the system object of the present invention.

In these figures reference is made to a set of elements which are the following:

1. Fresnel lens concentrator
2. secondary optical element
3. intake face of the secondary optical element
4. rim of the secondary optical element
5. circular transverse section
6. pyramidal section of the secondary optical element
7. lower end of the pyramidal section of the secondary optical element

## DESCRIPTION OF PREFERRED EMBODIMENTS OF THE INVENTION

Next, there is a detailed description of a preferred embodiment of the design parameters describing the Fresnel lens concentrator 1 and the secondary optical element 2.

The system described is defined by a geometrical concentration of 1000X concentrating the radiation in a 5.5x 5.5 mm$^2$ photovoltaic cell. This defines a 174x174 mm$^2$ Fresnel lens concentrator 1. The F# of the lens 1 has been fixed in 1.2. Said value is considered a compromise between system compactness and use of etendue.

The design of the lens 1 is fixed in the following manner:

The central part of the lens has a constant thickness design of 1 mm. Said thickness enables to have a lens with good efficiency and good off axis behaviour, thus improving the system acceptance angle.

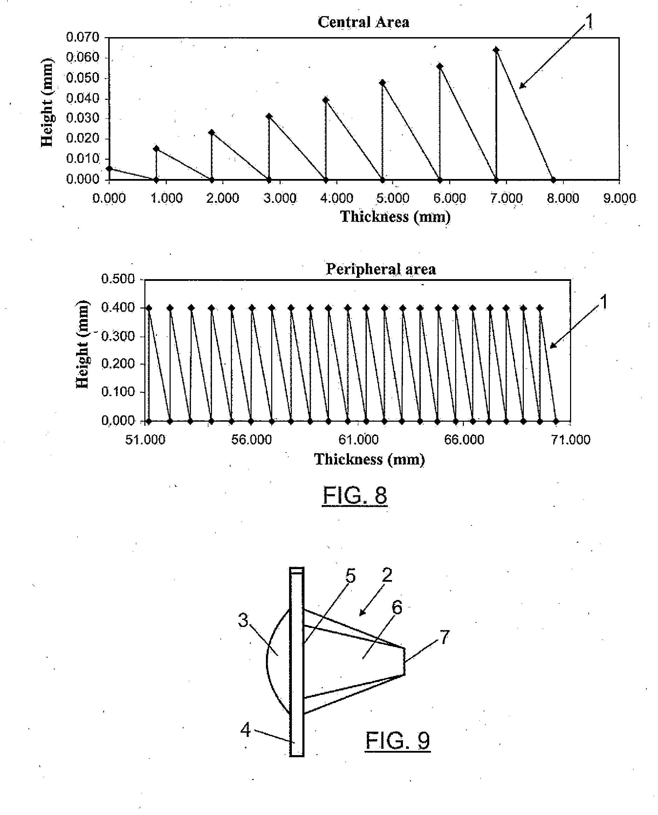

Once a maximum of 0.4mm height is reached for the lens facet height, said maximum is maintained until reaching the outer edge of the facet. Figure 8 shows the profile of said hybrid lens.

The secondary optical element 2 has been optimized for an acceptance' angle of 1.4°. Figure 9 shows the design of the secondary optical element 2, which together with the Freshet lens concentrator 1 is capable of fixing the performance of 1000X and the acceptance angle of 1.4°.

Another preferred embodiment of the concentrated photovoltaic solar system object of the present invention is defined by a geometrical concentration of 700X with the F# of the lens 1 fixed in 1.2 and a secondary optical element 2 with an acceptance angle of 1.91°.

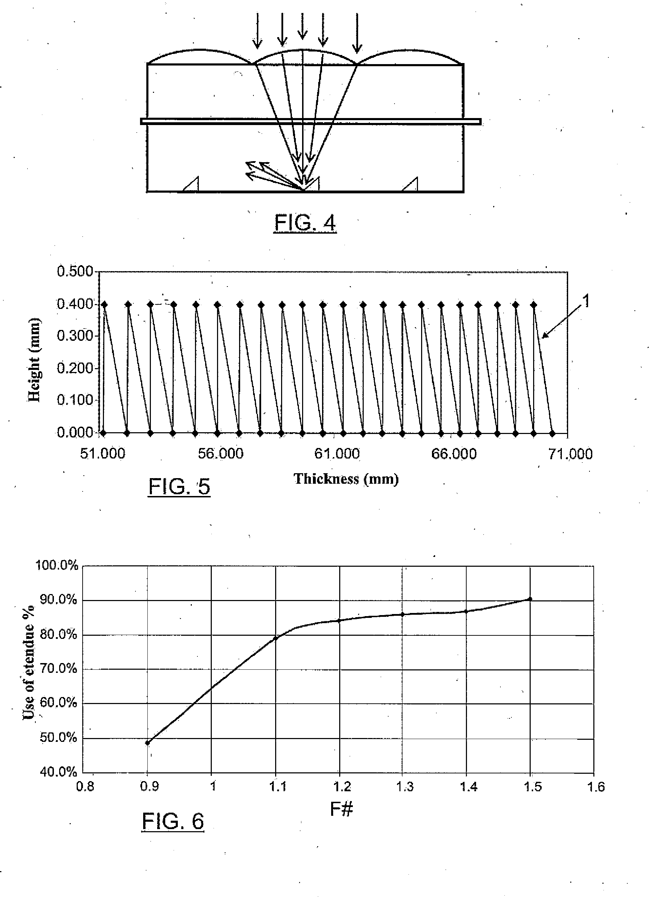

Figure 6 shows the relation between F# and the etendue of the system object of the present invention.

According to a preferred embodiment of the invention which can be observed in the drawings, the secondary optical element 2 has a curve convex intake face 3, and a truncated pyramid-shaped section 6 in its lower part. Also, the system comprises a rim 4 arranged around the intake face 3 of the secondary optical element 2, said rim having a square or circular shape. This rim 4 can be optically active, or inactive, and it can be made in a part integral to the secondary optical element 2, or in a manner independent from it.

Preferably, the secondary optical element 2, has next to the intake face 3 a circular transverse section 5, which is progressively transformed into a square transverse section until reaching the lower end 7 of the truncated pyramid-shaped section 6, said lower end 7 being where the photovoltaic receiver is fixed.

Once the invention has been clearly described, it is highlighted that the, particular embodiments described above can be modified in detail as long as they do not alter the fundamental principle and essence of the invention.

**Claims**

1.  Concentrated photovoltaic solar system comprising

    - a Fresnel lens concentrator (1),
    - a secondary optical element (2), and
    - a photovoltaic receiver,

    said concentrated photovoltaic solar system **characterized in that** the Fresnel lens concentrator (1) is a hybrid lens comprising

    - at least one first area with a constant facet thickness, and
    - at least one second area with a constant facet height.

2.  Concentrated photovoltaic solar system according to claim 1, **characterized in that** the first area with a constant facet thickness is the central area of the Fresnel lens concentrator (1).

3.  Concentrated photovoltaic solar system according to any of the preceding claims, **characterized in that** the first area of the Fresnel lens concentrator (1) with the constant facet thickness has a thickness equal to or smaller than 1 mm.

4.  Concentrated photovoltaic solar system according to claim 1, **characterized in that** the area with constant facet height is the peripheral area of the Fresnel lens concentrator (1).

5.  Concentrated photovoltaic solar system according to any of the preceding claims, **characterized in that** the Fresnel lens concentrator (1) in the central area with constant thickness increases the facet height up to a maximum height point, as the number of facets of said Fresnel lens concentrator (1) increases.

6.  Concentrated photovoltaic solar system comprising

    - a Fresnel lens concentrator (1),
    - a secondary optical element (2), and
    - a photovoltaic receiver

    **characterized in that**

- the secondary optical element (2) in turn comprises a curve convex intake face (3).
- and **in that** said secondary optical element (2) has a truncated pyramid-shaped section (6).

7. Concentrated photovoltaic solar system according to claim 6, **characterized in that** the secondary optical element (2) comprises a rim (4) arranged around the intake face (3).

8. Concentrated photovoltaic solar system according to the preceding claim, **characterized in that** the rim (4) has a geometrical shape selected between square and circular.

9. Concentrated photovoltaic solar system according to any of the claims 7 to 8, **characterized in that** the rim (4) of the secondary optical element (2) is optically inactive.

10. Concentrated photovoltaic solar system according to any of the claims 7 to 8, **characterized in that** the rim (4) of the secondary optical element (2) is optically active.

11. Concentrated photovoltaic solar system according to any of the claims 7 to 10, **characterized in that** the rim (4) is integral to the secondary optical element (2).

12. Concentrated photovoltaic solar system according to any of the claims 7 to 10, **characterized in that** the rim (4) is independent from the secondary optical element (2).

13. Concentrated photovoltaic solar system according to any of the claims 6 to 12, **characterized in that**

- the secondary optical element (2), next to the intake face (3) comprises a circular transverse section (5),
- and **in that** said circular transverse section (5} progressively becomes a square transverse section until reaching the lower end (7) of the truncated pyramid-shaped section (6) of the secondary optical element (2).

14. Concentrated photovoltaic solar system according to any of the preceding claims, **characterized in that** the use of etendue in said concentrated photovoltaic solar system ranges between 45% and 95%.

15. Concentrated photovoltaic solar system according to the preceding claim, **characterized in that**

- the Fresnel lens concentrator (1) has

  - a focal length of said lens (1) to the secondary optical element (2) f,
  and
  - a diagonal of the light intake face in the lens (1) D,

the relation F# = f/D ranging between 0.9 and 1.5,
- and **in that** the secondary optical element (2) has an acceptance angle ranging between 1.20° and 1.99°.

16. Concentrated photovoltaic solar system according to the preceding claim, **characterized in that** it comprises

- a geometrical concentration of 1000X,
- a Fresnel lens concentrator (1) with a relation F# = 1.2, and
- a secondary optical element (2) with an acceptance angle of 1.4°.

17. Concentrated photovoltaic solar system according to the preceding claim, **characterized in that**

- the constant thickness of the facet in the central area of the Fresnel lens concentrator (1) is smaller than or equal to 1 mm,
- and **in that** in said central area the height of the facet increases in a progressive manner until reaching a maximum height of 0.4mm, said maximum height of 0.4mm being kept constant until the facet of the outer edge of the Fresnel lens concentrator (1).

18. Concentrated photovoltaic solar system according to the preceding claim, **characterized in that** it comprises

- a geometrical concentration of 700X,

- a Fresnel lens concentrator (1) with a relation F# = 1.2, and
- a secondary optical element (2) with an acceptance angle of 1.91 °.

FIG. 1

FIG. 2

FIG. 3

FIG. 4

FIG. 5

FIG. 6

a)

b)

FIG. 7

FIG. 8

FIG. 9

# INTERNATIONAL SEARCH REPORT

| | International application No. |
|---|---|
| | PCT/ES2011/070065 |

A. CLASSIFICATION OF SUBJECT MATTER

*G02B19/00* (2006.01)
*H01L31/052* (2006.01)
According to International Patent Classification (IPC) or to both national classification and IPC

B. FIELDS SEARCHED

Minimum documentation searched (classification system followed by classification symbols)
G02B, H01L, F24J

Documentation searched other than minimum documentation to the extent that such documents are included in the fields searched

Electronic data base consulted during the international search (name of data base and, where practicable, search terms used)

EPODOC, INVENES, WPI, INSPEC

C. DOCUMENTS CONSIDERED TO BE RELEVANT

| Category* | Citation of document, with indication, where appropriate, of the relevant passages | Relevant to claim No. |
|---|---|---|
| A | US 2009/0314347 A1 (KLEINWAECHTER, J.) 24.12.2009, abstract; paragraphs [0011]-[0024]; figures 1 and 2. | 1, 14-16 |
| Y | | 6, 13 |
| A | US 2005/0092360 A1 (CLARK, R.) 05.05.2005, abstract; paragraphs [0006], [0023]-[0026], [0030]-[0031]; figures 1, 3g and 4. | 1, 2, 4, 14-16 |
| Y | | 6, 13 |
| A | US 2005/0051205 A1 (MOOK, JR.) 10.03.2005, abstract; paragraphs [0019]-[0022], [0077], [0080]-[0081]; figures 12, 13, 15 and 16b. | 1, 6, 14 |
| A | DE 19600813 A1 (ECKERT, M.) 18.07.1996, the whole the document. | 1, 6, 13 |

☒ Further documents are listed in the continuation of Box C.   ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 22/06/2011 | **(28//06/2011)** |
| Name and mailing address of the ISA/ | Authorized officer |
| | Ó. González Peñalba |
| OFICINA ESPAÑOLA DE PATENTES Y MARCAS | |
| Paseo de la Castellana, 75 - 28071 Madrid (España) | |
| Facsimile No.: 91 349 53 04 | Telephone No. 91 3495475 |

Form PCT/ISA/210 (second sheet) (July 2009)

EP 2 538 261 A1

# INTERNATIONAL SEARCH REPORT

| | International application No. |
|---|---|
| | PCT/ES2011/070065 |

| C (continuation). | DOCUMENTS CONSIDERED TO BE RELEVANT | |
|---|---|---|
| Category * | Citation of documents, with indication, where appropriate, of the relevant passages | Relevant to claim No. |
| A | WO 2006/065246 A1 (COBERT, D.) 22.06.2006, the whole document. | 1, 6-8, 10, 12, 13 |
| A | US 2008/0087323 A1 (ARAKI, K. ET AL.) 17.04.2008, abstract; paragraphs [0060]-[0064]; figures 3 and 4. | 1, 6, 13 |
| A | US 4114592 A (WINSTON, R.) 19.09.1978., | - |

Form PCT/ISA/210 (continuation of second sheet) (July 2009)

## INTERNATIONAL SEARCH REPORT

Information on patent family members

International application No.

PCT/ES2011/070065

| Patent document cited in the search report | Publication date | Patent family member(s) | Publication date |
|---|---|---|---|
| US2009314347 A | 24.12.2009 | WO2008034418 A<br>DE102006044603 A<br>EP2066986 A<br>EP20070817530<br>DE112007002830 A | 27.03.2008<br>27.03.2008<br>10.06.2009<br>17.09.2007<br>24.09.2009 |
| US2005092360 A | 05.05.2005 | US2008066799 A | 20.03.2008 |
| US2005051205 A | 10.03.2005 | US7081584 B<br>WO2005026626 A | 25.07.2006<br>24.03.2005 |
| DE19600813 A | 18.07.1996 | NONE | |
| WO2006065246 A | 22.06.2006 | NONE | |
| US2008087323 A | 17.04.2008 | JP2006313809 A<br>JP2007201109 A | 16.11.2006<br>09.08.2007 |
| US4114592 A | 19.09.1978 | DE2736907 AC<br>JP53023648 A<br>FR2362408 AB<br>CA1074648 A<br>GB1580852 A<br>JP59112202 U<br>JP62002562Y2 | 23.02.1978<br>04.03.1978<br>17.03.1978<br>01.04.1980<br>03.12.1980<br>28.07.1984<br>21.01.1987 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006114457 A
- US 2009106648 A
- WO 2009058603 A
- WO 2009086293 A
- WO 2008131566 A